# EUROPEAN PATENT APPLICATION

(11) **EP 4 766 088 A1**
(43) Date of publication of application: **24.06.2026**
(21) Application number: 25216478.5
(22) Date of filing: 17.11.2025
(51) Int. Cl.: H10D 84/01, H10D 30/01, H10D 30/00, H10D 64/23, H10D 84/85, H10D 84/83, H10D 84/03

(54) **ARCHITECTURES AND METHODS FOR DIFFERENTIAL CMOS CONTACT PROFILES**

(30) Priority: 17.12.2024 US 202418984414
(71) Applicant: Intel Corporation, Santa Clara, CA 95054 (US)
(72) Inventor: ZELICK, Nancy, Baker City, OR 97814 (US); HARATIPOUR, Nazila, Portland, OR 97239 (US); DEWEY, Gilbert, Beaverton, OR 97006 (US); LI, Wenshen, Fremont, CA 94555 (US); SEARS, Paul D., Beaverton, OR 97003 (US); BONSU, Richard O., Hillsboro, OR 97124 (US); GEORGE, Mekha R., Hillsboro, OR 97124 (US)
(74) Representative: Samson & Partner Patentanwälte mbB

(57) **Abstract**

Architectures and methods for differential CMOS contact profiles. Architectures include a CMOS isolation layer with a plurality of negative metal oxide semiconductor (NMOS) regions and a plurality of positive metal oxide semiconductor (PMOS) regions. The NMOS regions have a respective NMOS contact characterized by a first cavity formed in an upper surface of the isolation layer, extending orthogonally into the NMOS region to a first depth, and filled with a conductive material. The PMOS regions have a respective PMOS contact characterized by a second cavity formed in the upper surface of the isolation layer, extending orthogonally into the PMOS region to a second depth, and filled with the conductive material. The first depth is more than four times the second depth.

## Description

### BACKGROUND

Contact resistance of a field effect transistor (FET) refers to the resistance measured at the interface between a source region of the channel material and a contact metal on source region as well as between a drain region of the channel material and a contact metal on the drain region. Contact resistance directly impacts the performance of the transistor and determines the maximum drive current and clock frequency achievable by devices utilizing FETs.

### BRIEF DESCRIPTION OF THE DRAWINGS

FIG. 1 is a simplified cross-sectional diagram of a differential CMOS contact profile, in accordance with various embodiments described herein.
FIG. 2 is an enlargement of the NMOS-PMOS portion of FIG. 1, for discussion of features of various embodiments described herein.
FIG. 3 is an enlargement of the NMOS-PMOS portion of FIG. 1, for discussion of features of various other embodiments described herein.
FIG. 4 illustrates the embodiment of FIG. 2, with fill material in the contacts.
FIG. 5 illustrates the embodiment of FIG. 3, with fill material in the contacts.
FIG. 6 illustrates an example method for manufacturing various embodiments described herein.
FIG. 7 is a top view of a wafer and dies that may be included in a microelectronic assembly, in accordance with any of the embodiments disclosed herein.
FIG. 8 is a simplified cross-sectional side view showing an implementation of an integrated circuit on a die that may be included in various embodiments, in accordance with any of the embodiments disclosed herein.
FIG. 9A, FIG. 9B, FIG. 9C and FIG.9D are simplified perspective views of example planar, FinFET, gate-all-around, and stacked gate-all-around transistors, as may be implemented in various embodiments.
FIG. 10 is a cross-sectional side view of a microelectronic assembly that may include any of the embodiments disclosed herein.
FIG. 11 is a block diagram of an example electrical device that may include any of the embodiments disclosed herein.

### DETAILED DESCRIPTION

Complementary metal oxide semiconductor (CMOS) technology nodes may be characterized by the performance of the respective Field Effect Transistor (FET) drain currents (I_{DS}) and gate to source voltages (V_{GS}). Additionally, FET performance is impacted by contact resistance, which directly impacts the performance of a transistor and determines the maximum drive current and clock frequency achievable in devices utilizing these transistors. As used herein, "contact resistance" is a resistance measured at the interface between a source material and a source contact metal and/or between a drain material and a drain contact metal. Although technically challenging, to achieve transistor/device performance goals, it is desirable to reduce the contact resistance in negative metal oxide semiconductor (NMOS) transistors without degrading the mobility in the positive metal oxide semiconductor (PMOS) transistors. Degrading the mobility in the positive metal oxide semiconductor (PMOS) transistors can also be referred to as relaxation of the strain in the P-type epitaxial layer.

The contact resistance is a function of at least the surface area of the contact (also referred to herein as the contact profile). In many available CMOS architectures, the contact profiles of the NMOS transistors and CMOS transistors are the same.

Embodiments disclosed herein propose a technical solution to the above-described technical problems in the form of architectures and methods for differential CMOS contact profiles. The method includes 1) intentionally forming deeper, V-shaped contact profiles in the NMOS source regions and 2) creating a differential contact profile between the NMOS and PMOS regions. The proposed methodology reduces end of line (EOL) contact resistivity and external resistance, while preventing PMOS mobility loss. Contact resistivity reduction without mobility degradation will increase transistor current in the on-state at iso capacitance. As used herein, "iso capacitance" means the same capacitance, or no increase/decrease in capacitance, this is significant because generally a reduction in resistance, without an increase in a contact trench, would typically result in a higher parasitic capacitance. The proposed methodology and architecture improve yield and transistor switching speed. This proposal can be integrated across multiple technologies.

Aspects of the present disclosure may be discoverable using cross-sectional transmission electron microscopy (TEM) images and corresponding compositional analysis, such as Time of Flight Secondary Ion Mass Spectrometry (ToF SIMS), or electron energy loss spectroscopy (EELS) to reveal the stoichiometry and electronic structure. Additionally, the contact resistance, and certain performance targets and mobility measures, described in more detail below, can reveal that aspects of the present disclosure have been practiced.

Example embodiments are hereinafter described in conjunction with the following drawing figures, wherein like numerals denote like elements. Figures are not necessarily to scale but may be relied on for spatial orientation and relative positioning of features. As may be appreciated, certain terminology, such as "ceiling" and "floor", as well as "upper,", "uppermost", "lower," "above," "below," "bottom," and "top" refer to directions based on viewing the Figures to which reference is made. Further, terms such as "front," "back," "rear,", "side", "vertical", and "horizontal" may describe the orientation and/or location of portions of the component within a consistent but arbitrary frame of reference which is made clear by reference to the text and the associated Figures describing the component under discussion. Such terminology may include the words specifically mentioned above, derivatives thereof, and words of similar import.

The following detailed description is not intended to limit the application and use of the disclosed technologies. It may be evident that the novel embodiments can be practiced without every detail described herein. For the sake of brevity, well-known structures and devices may be shown in block diagram form to facilitate a description thereof.

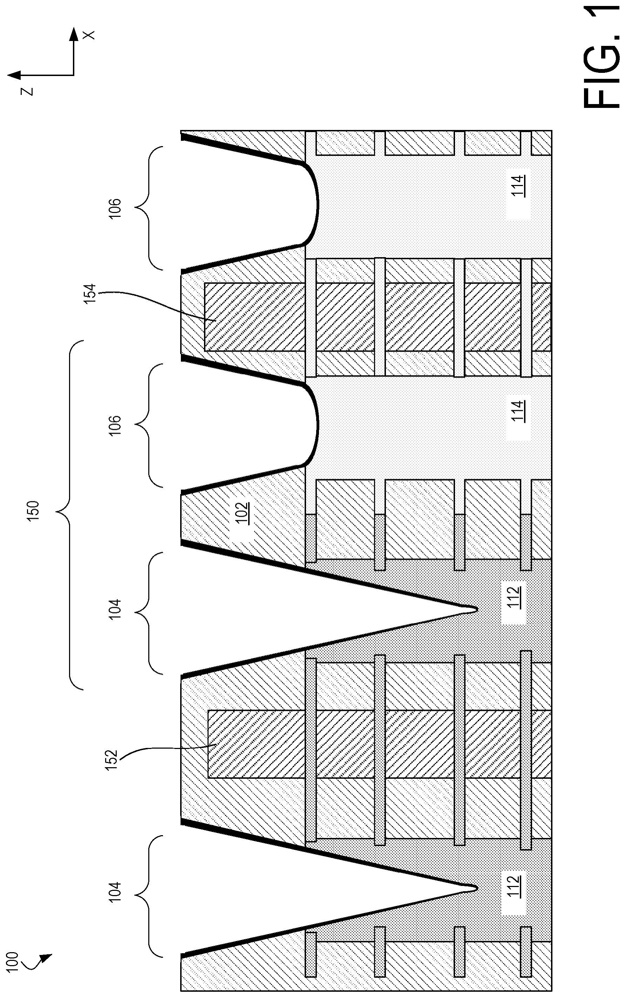

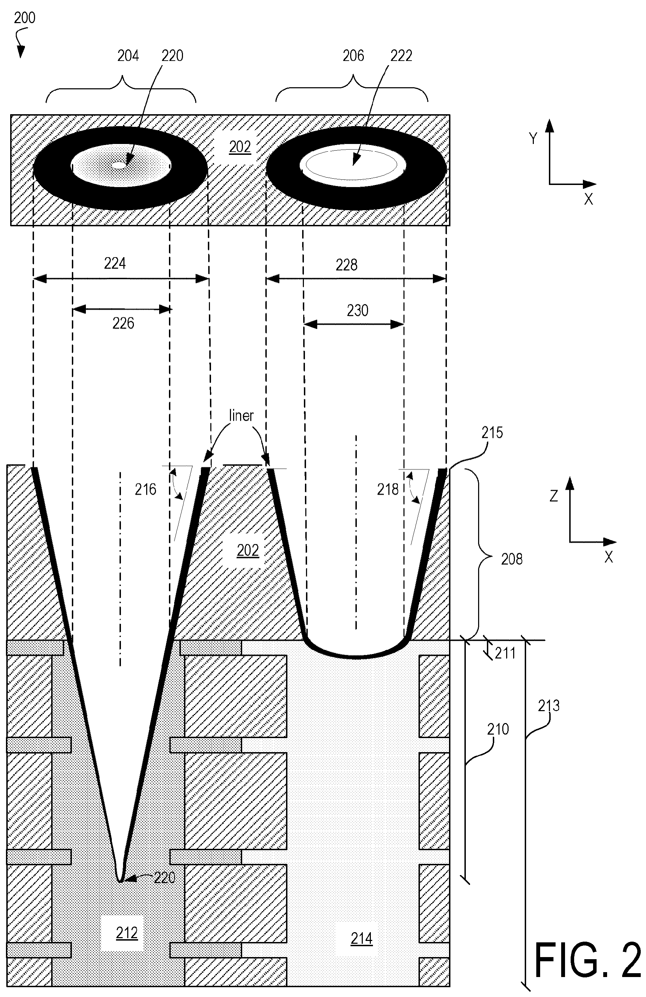

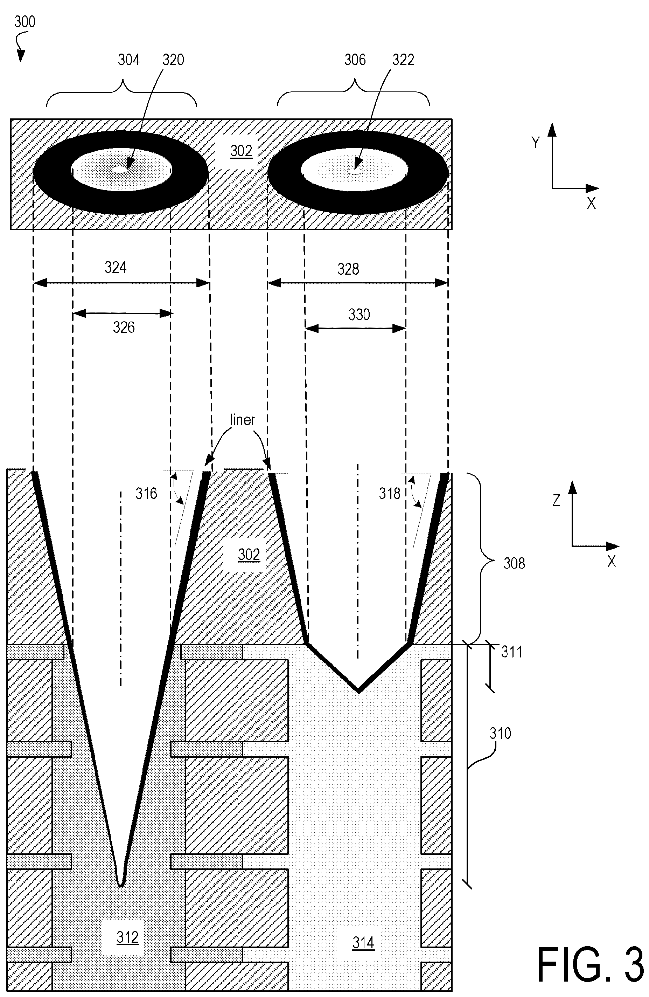

FIG. 1 is a simplified cross-sectional diagram 100 of a differential CMOS contact profile, in accordance with various embodiments described herein. The NMOS-PMOS portion 150 of FIG. 1 is enlarged showing an exemplary embodiment 200 in FIG. 2 and enlarged showing another exemplary embodiment 300 in FIG. 3.

The isolation layer 102/202/302/402/502 has two NMOS source contacts 104/204/304/404/504 and two PMOS drain contacts 106/206/306/406/506. The N-epitaxial deposit for a source region 112/212/312/414/514 and the P-epitaxial deposit for a drain region 114/214/314/414/514 are indicated, with 4 bands or channels depicted running horizontally across the vertically oriented gate ribbons (the first gate 152 and the second gate 154). However, in other embodiments, there may be any number of bands, or even no bands (e.g., 1 band, 2 bands, 3 bands, etc.).

In some embodiments, the isolation layer comprises oxide. In various embodiments, the isolation layer may comprise, e.g., nitride, oxycarbide, oxynitride, silicon oxide, gallium nitride, or other suitable material.

Embodiments of the NMOS contacts 104/204/304 and PMOS contacts 106/206/306 are formed with a cavity extending orthogonally downward from the upper surface of the substrate layer, the cavity characterized by a sidewall that is coaxial around an axis. As described in more detail below, the cavities may be lined and filled.

The sidewalls of the NMOS contacts 104/204/304 and PMOS contacts 106/206/306 are depicted with a thick black lining referred to herein as a liner layer. The liner layer comprises a thickness of less than or equal to 20 nanometers +/-5 nanometers (nm). The liner layer comprises a material that is conductive, with a low resistivity, compared to the material of the Isolation Layer. In various embodiments, the liner layer may comprise titanium, tungsten, nickel, aluminum, and/or antimony. The liner layer, when present, surrounds the fill material of a contact.

As shown in embodiment 200, the opening of the NMOS contacts and the PMOS contacts, when viewed in a plan view (also referred to as a top-down view, or an X-Y view) from the upper surface of the isolation layer may appear oval or circular. In the cross-sectional views (i.e., Z-X), the sidewalls of the contacts 104/204/304 and the contacts 106/206/306 appear to taper slightly from perpendicular to the upper surface of the substrate layer.

For illustration, this taper is exaggerated and indicated with angle 216/316 for the NMOS contacts slope, and angle 218/318 for the PMOS contacts slope, and using a (NMOS contact) surface cavity diameter 224/324 and second diameter 226/326 at the source region 216/316 and (PMOS contact) surface cavity diameter 228/328 and second diameter 230/330 at the source region 214/314. In a non-limiting embodiment, the NMOS contact surface cavity diameter 224/324 and PMOS contact surface cavity diameter 228/328 are in a range of 16-20 nm, inclusive.

While the illustrations in FIG. 2 and FIG. 3 are not to-scale, it is intentional that the NMOS contact cavity (also called a trench contact) extends through a thickness 203/308 of substrate layer material and into the NMOS source region 312, past the first channel, to a depth 210/310 that is around the second or third channel (the images depict it just past the third channel), while the P contact cavity only extends into the PMOS drain region 314 to around the first channel (to a depth 211/311). In a non-limiting example, the NMOS source region and PMOS drain region have a total depth 213 of 100 nm +/- 20%. In various embodiments, the depths 210/310 may be in a range of 50-60 nm, inclusive. In contrast, the P contacts are shallower; e.g., the depth 211 may be 5 nm +/- 4nm, as illustrated in embodiment 200, and depth 311 may be 10 nm, +/-4 nm. Stated differently, the NMOS contact depth (in the source region) is more than four times the PMOS contact depth (in the drain region).

Accordingly, in embodiments 200 and 300, the NMOS trench contact may appear like a needle or V-shape with the bottom of the NMOS trench contact having a relatively small diameter 220/320 that is more than 5 times smaller than diameter 224 on the upper surface of the substrate material, whereas the PMOS contacts may appear like an oval or flat (with bottom diameter 222) or appear arrow-shaped, as in embodiment 300, with bottom diameter 322. The thickness of the isolation material above the source and drain region (308/408) is in a range 10 nm to 200 nm. In various embodiments, the NMOS contact may have an aspect ratio in a range of 1 to 5, inclusive, comparing the diameter 224 on the upper surface 215 of the substrate layer to the depth of the contact from the upper surface 215 to the bottom diameter 220/320.

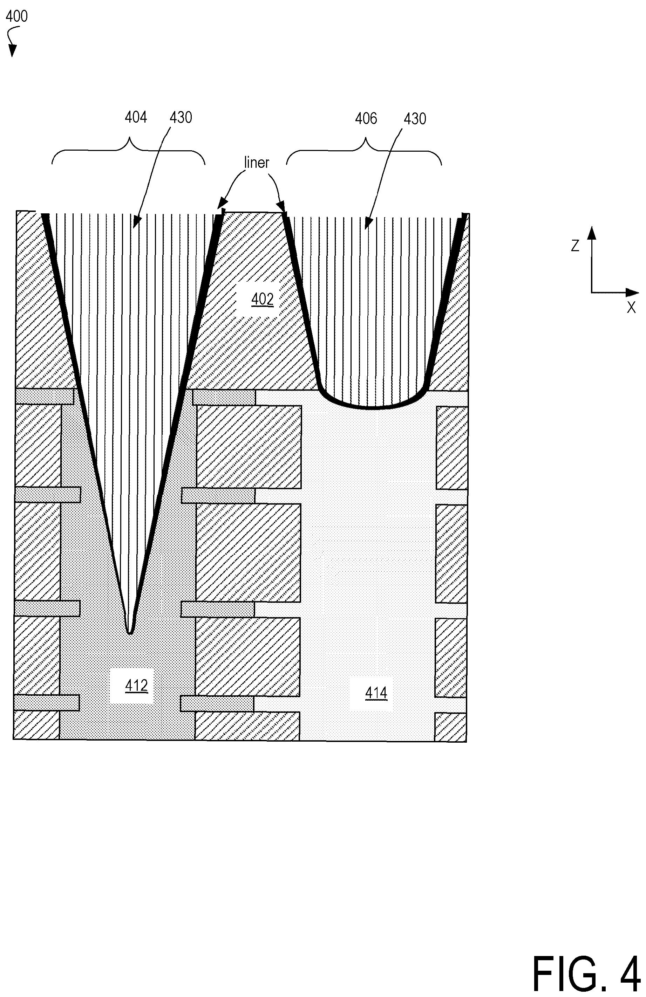

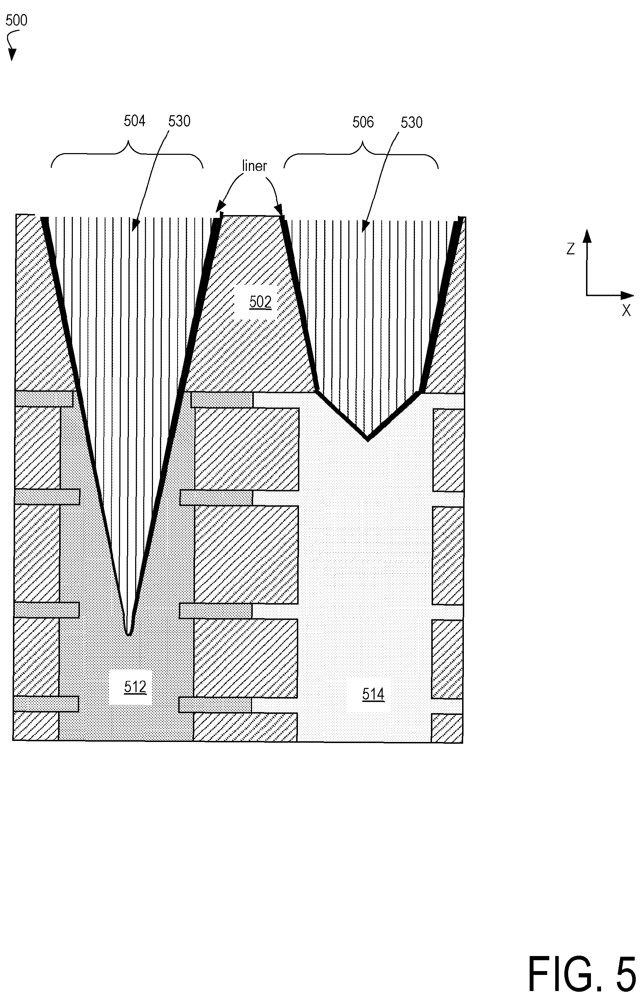

Turning to FIGS. 4 and 5, and with continued reference to FIGS. 1-3, the respective cavities of the CMOS contacts may have a fill material 430/530 deposited therein. In some embodiments, the fill material 430/530 can comprise one or more of tungsten, cobalt, molybdenum, and tungsten nitride TiN.

As mentioned, embodiments may be discoverable using cross-sectional transmission electron microscopy (TEM) images and corresponding compositional analysis, such as Time of Flight Secondary Ion Mass Spectrometry (ToF SIMS), or electron energy loss spectroscopy (EELS) to reveal the stoichiometry and electronic structure. Identifiable features include a NMOS trench contact with increased contact area compared to existing architectures, moreover the NMOS contact may comprise a needle or V-shape that extends into the N-epitaxial deposit beyond the first channel. The PMOS contact may have an oval shape (embodiment 200) or an arrow shape (embodiment 300). Embodiments advantageously can provide at least a 20% improvement in the resistance of the contact (Rc), which can support larger currents, smaller time delays and hence faster switching speeds or frequencies in products and devices that implement these embodiments.

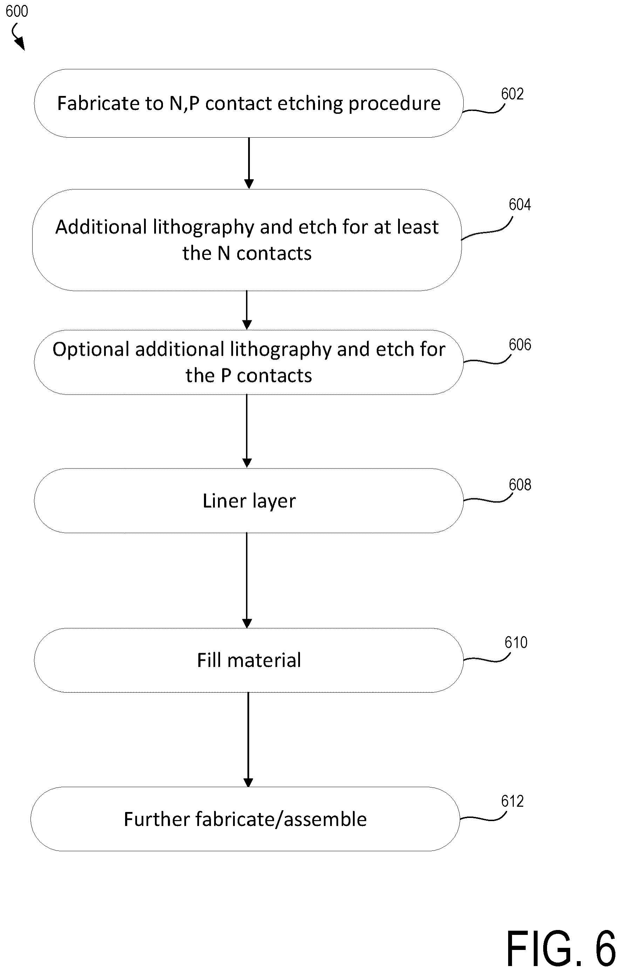

FIG. 6 is a flowchart for an exemplary method for fabricating embodiments described herein. The method 600 may be executed by a technician and/or by one or more automated machines. In some embodiments, one or more machines may be programmed to do some or all of the steps of the method 600. Such a machine may include, e.g., a memory, a processor, data storage, etc. The memory and/or data storage may store instructions that, when executed by the machine, cause the machine to perform some or all of the steps of the method 600. In addition to techniques specifically referenced herein, the method 600 may use any suitable set of techniques that are used in semiconductor processing, such as chemical vapor deposition, atomic layer deposition, physical vapor deposition, molecular beam epitaxy, pulsed laser deposition, layer transfer, photolithography, ion implantation, dry etching, wet etching, thermal treatments, etc.

In various embodiments, method 600 may be performed at the wafer scale. The wafer and hence the substrate layer may comprise silicon. In various embodiments, the substrate layer may comprise, e.g., silicon oxide, gallium nitride, or other suitable material. At 602, the substrate layer is CMOS fabricated up to the procedure for NMOS contact and PMOS contact etching. This implies the planning and placement of transistors, field effect transistors, and gate material, as well as the identification of respective source/drain locations and respective doping to create the source region and the drain region, with layers of resist and etching as is known in the industry.

Method 600 is distinguishable from available methods in that it creates the N contact and P contact profiles separately, to have different profiles. In contrast, available solutions create the n and p trench cavities at the same time, and they have similar profiles. At 604 additional lithography and etch tasks are added for at least the N contacts. A dry etch or plasma etch may be used to create the V-shape of the N contacts and the P contacts. This may be followed by a wet etch. At 606, additional lithography and etch tasks can be added for the P contacts. The tasks at 606 are optional, if they are not performed, the P contacts may be created using previously available methods.

At 608, the liner layer can be deposited in the cavities of the contacts, as indicated in FIGS. 1-5. At 610, the fill material is deposited in the N contacts and P contacts for the respective source regions 112 and drain regions 114. The fill material comprises a metal and can include (e.g., antimony, bismuth, platinum, palladium, copper, aluminum, nickel, cobalt, iron, tin, gold, silver, or combinations thereof). As used herein, when the cavity is "filled" it implies that sufficient fill material is distributed in the cavity to create an electrical path between the upper surface (the opening of the contact, in the plan view) of the substrate layer and the bottom of the cavity, thereby creating a contact.

At 612, embodiments with the above-described transistor architecture with differential CMOS contact profiles may be further fabricated or assembled into another device or package assembly. Accordingly, at 612, gate controls and material may be added, and singulation and assembly may be performed.

Thus, architectures and methods for differential CMOS contact profiles have been described. Contact resistivity reduction without mobility degradation will increase transistor on-state at iso capacitance and yield improved transistor switching speed. The following description and associated figures provide more detail for components referenced hereinabove.

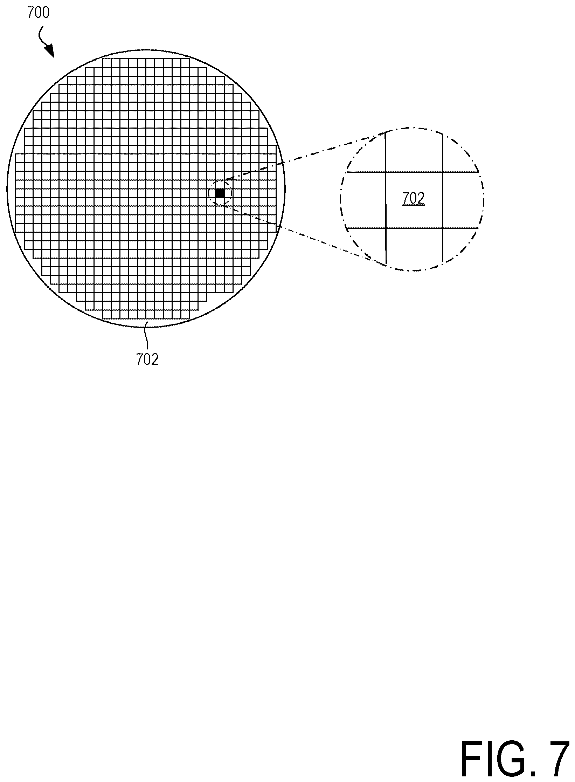

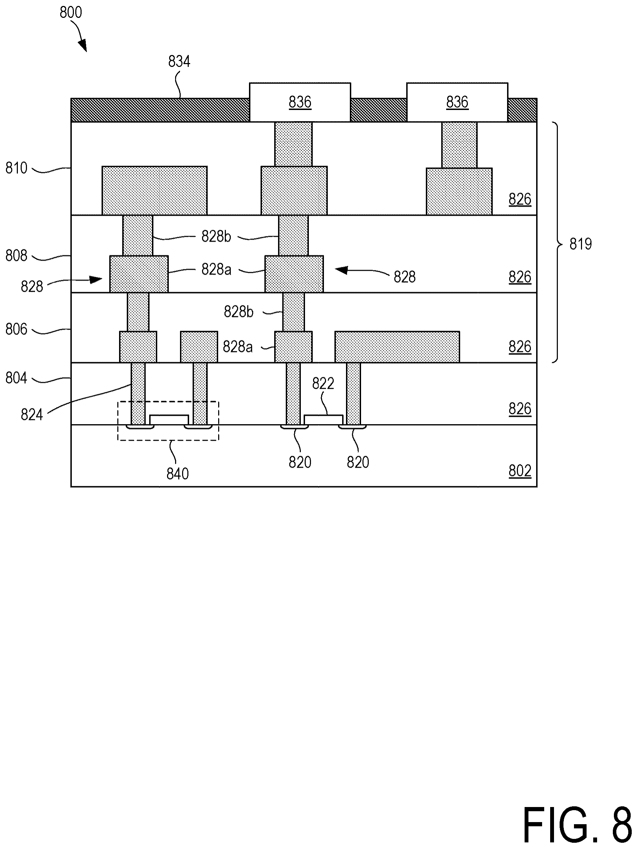

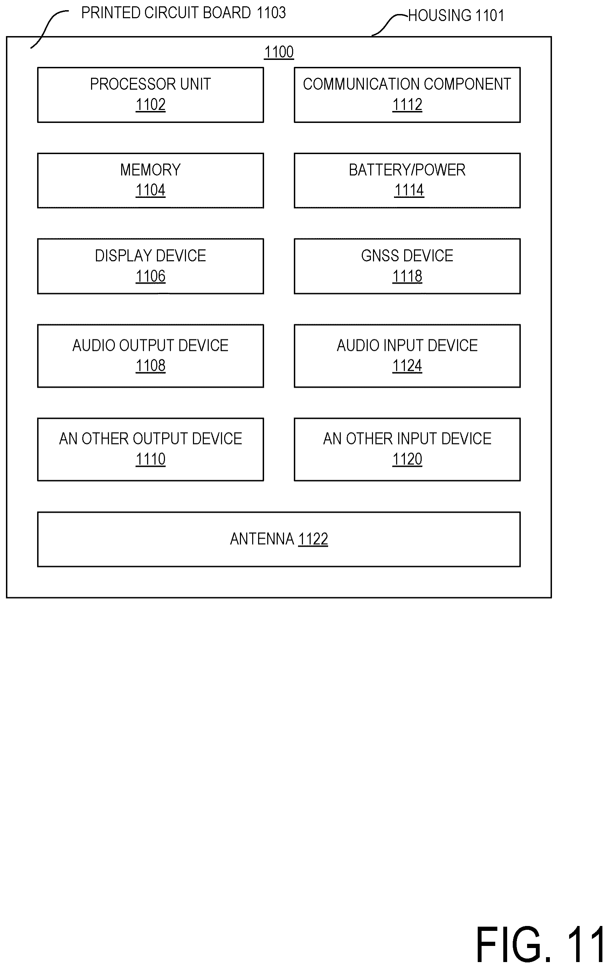

FIG. 7 is a top view of a wafer 700 and dies 702 that may be included in any of the embodiments disclosed herein. The wafer 700 may be composed of semiconductor material and may include one or more dies 702 formed on a surface of the wafer 700. After the fabrication of the integrated circuit components on the wafer 700 is complete, the wafer 700 may undergo a singulation process in which the dies 702 are separated from one another to provide discrete "chips" or destined for a packaged integrated circuit component. The individual dies 702, comprising an integrated circuit component, may include one or more transistors (e.g., some of the transistors 840 of FIG. 8, discussed below), supporting circuitry to route electrical signals to the transistors, passive components (e.g., signal traces, resistors, capacitors, or inductors), and/or any other integrated circuit components. In some embodiments, the wafer 700 or the die 702 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Additionally, multiple devices may be combined on a single die 702. For example, a memory array formed by multiple memory devices may be formed on a same die 702 as a processor unit (e.g., the processor unit 1102 of FIG. 11) or other logic that is configured to store information in the memory devices or execute instructions stored in the memory array. In some embodiments, a die 702 may be attached to a wafer 700 that includes other die, and the wafer 700 is subsequently singulated, this manufacturing procedure is referred to as a die-to-wafer assembly technique.

FIG. 8 is a cross-sectional side view of an integrated circuit 800 that may be included in any of the embodiments disclosed herein. One or more of the integrated circuits 800 may be included in one or more dies 702 (FIG. 7). The integrated circuit 800 may be formed on a die substrate 802 (e.g., the wafer 700 of FIG. 7) and may be included in a die (e.g., the die 702 of FIG. 7).

The die substrate 802 may be a semiconductor substrate composed of semiconductor material systems including, for example, n-type or p-type materials systems (or a combination of both). The die substrate 802 may include, for example, a crystalline substrate formed using a bulk silicon or a silicon-on-insulator (SOI) substructure. In some embodiments, the die substrate 802 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 802. Although a few examples of materials from which the die substrate 802 may be formed are described here, any material that may serve as a foundation for an integrated circuit 800 may be used. The die substrate 802 may be part of a singulated die (e.g., the dies 702 of FIG. 7) or a wafer (e.g., the wafer 700 of FIG. 7).

The integrated circuit 800 may include one or more device layers 804 disposed on the die substrate 802. The device layer 804 may include features of one or more transistors 840 (e.g., metal oxide semiconductor field-effect transistors (MOSFETs)) formed on the die substrate 802. The transistors 840 may include, for example, one or more source and/or drain (S/D) regions 820, a gate 822 to control current flow between the S/D regions 820, and one or more S/D contacts 824 to route electrical signals to/from the S/D regions 820.

The gate 822 may be formed of at least two layers, a gate dielectric, and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be conducted on the gate dielectric to improve its quality when a high-k material is used.

The gate electrode may be formed on the gate dielectric and may include at least one p-type work function metal or n-type work function metal, depending on whether the transistor 840 is to be a p-type metal oxide semiconductor (PMOS) or an n-type metal oxide semiconductor (NMOS) transistor. In some implementations, the gate electrode may comprise a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 840 along the source-channel-drain direction, the gate electrode may comprise a U-shaped structure that includes a bottom portion substantially parallel to the surface of the die substrate 802 and two sidewall portions that are substantially perpendicular to the top surface of the die substrate 802. In other embodiments, at least one of the metal layers that form the gate electrode may simply be a planar layer that is substantially parallel to the top surface of the die substrate 802 and does not include sidewall portions substantially perpendicular to the top surface of the die substrate 802. In other embodiments, the gate electrode may comprise a combination of U-shaped structures and planar, non-U-shaped structures. For example, the gate electrode may comprise one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and include deposition and etching process steps. In some embodiments, a plurality of spacer pairs may be used; for instance, two pairs, three pairs, or four pairs of sidewall spacers may be formed on opposing sides of the gate stack.

The S/D regions 820 may be formed within the die substrate 802 adjacent to the gate 822 of individual transistors 840. The S/D regions 820 may be formed using an implantation/diffusion process or an etching/deposition process, for example. In the former process, dopants such as boron, aluminum, antimony, phosphorous, or arsenic may be ion-implanted into the die substrate 802 to form the S/D regions 820. An annealing process that activates the dopants and causes them to diffuse farther into the die substrate 802 may follow the ion-implantation process. In the latter process, the die substrate 802 may first be etched to form recesses at the locations of the S/D regions 820. An epitaxial deposition process may then be conducted to fill the recesses with material that is used to fabricate the S/D regions 820. In some implementations, the S/D regions 820 may be fabricated using a silicon alloy such as silicon germanium or silicon carbide. In some embodiments, the epitaxially deposited silicon alloy may be doped in situ with dopants such as boron, arsenic, phosphorous, yttrium, bismuth, antimony, scandium, vanadium, tellurium. In some embodiments, the S/D regions 820 may be formed using one or more alternate semiconductor materials such as germanium or a group III-V material or alloy. In further embodiments, one or more layers of metal and/or metal alloys may be used to form the S/D regions 820.

Electrical signals, such as power and/or input/output (I/O) signals, may be routed to and/or from the devices (e.g., transistors 840) of the device layer 804 through one or more interconnect layers disposed on the device layer 804 (illustrated in FIG. 8 as interconnect layers 806-810). For example, electrically conductive features of the device layer 804 (e.g., the gate 822 and the S/D contacts 824) may be electrically coupled with the interconnect structures 828 of the interconnect layers 806-810. The one or more interconnect layers 806-810 may form a metallization stack (also referred to as an "ILD stack") 819 of the integrated circuit 800.

The interconnect structures 828 may be arranged within the interconnect layers 806-810 to route electrical signals according to a wide variety of designs; in particular, the arrangement is not limited to the particular configuration of interconnect structures 828 depicted in FIG. 8. Although a particular number of interconnect layers 806-810 is depicted in FIG. 8, embodiments of the present disclosure include integrated circuits having more or fewer interconnect layers than depicted.

In some embodiments, the interconnect structures 828 may include lines 828a and/or vias 828b filled with an electrically conductive material such as a metal. The lines 828a may be arranged to route electrical signals in a direction of a plane that is substantially parallel with a surface of the die substrate 802 upon which the device layer 804 is formed. For example, the lines 828a may route electrical signals in a direction in and out of the page and/or in a direction across the page. The vias 828b may be arranged to route electrical signals in a direction of a plane that is substantially perpendicular to the surface of the die substrate 802 upon which the device layer 804 is formed. In some embodiments, the vias 828b may electrically couple lines 828a of different interconnect layers 806-810 together.

The interconnect layers 806-810 may include a dielectric material 826 disposed between the interconnect structures 828, as shown in FIG. 8. In some embodiments, dielectric material 826 disposed between the interconnect structures 828 in different ones of the interconnect layers 806-810 may have different compositions; in other embodiments, the composition of the dielectric material 826 between different interconnect layers 806-810 may be the same. The device layer 804 may include a dielectric material 826 disposed between the transistors 840 and a bottom layer of the metallization stack as well. The dielectric material 826 included in the device layer 804 may have a different composition than the dielectric material 826 included in the interconnect layers 806-810; in other embodiments, the composition of the dielectric material 826 in the device layer 804 may be the same as a dielectric material 826 included in any one of the interconnect layers 806-810.

A first interconnect layer 806 (referred to as Metal 1 or "M1") may be formed directly on the device layer 804. In some embodiments, the first interconnect layer 806 may include lines 828a and/or vias 828b, as shown. The lines 828a of the first interconnect layer 806 may be coupled with contacts (e.g., the S/D contacts 824) of the device layer 804. The vias 828b of the first interconnect layer 806 may be coupled with the lines 828a of a second interconnect layer 808.

The second interconnect layer 808 (referred to as Metal 2 or "M2") may be formed directly on the first interconnect layer 806. In some embodiments, the second interconnect layer 808 may include via 828b to couple the lines 828a/b of the second interconnect layer 808 with the lines 828a of a third interconnect layer 810. Although the lines 828a and the vias 828b are structurally delineated with a line within individual interconnect layers for the sake of clarity, the lines 828a and the vias 828b may be structurally and/or materially contiguous (e.g., simultaneously filled during a dual-damascene process) in some embodiments.

The third interconnect layer 810 (referred to as Metal 3 or "M3") (and additional interconnect layers, as desired) may be formed in succession on the second interconnect layer 808 according to similar techniques and configurations described in connection with the second interconnect layer 808 or the first interconnect layer 806. In some embodiments, the interconnect layers that are "higher up" in the metallization stack 819 in the integrated circuit 800 (i.e., farther away from the device layer 804) may be thicker that the interconnect layers that are lower in the metallization stack 819, with lines 828a and vias 828b in the higher interconnect layers being thicker than those in the lower interconnect layers.

The integrated circuit 800 may include a solder resist material 834 (e.g., polyimide or similar material) and one or more conductive contacts 836 formed on the interconnect layers 806-810. In FIG. 8, the conductive contacts 836 are illustrated as taking the form of bond pads. The conductive contacts 836 may be electrically coupled with the interconnect structures 828 and configured to route the electrical signals of the transistor(s) 840 to external devices. For example, solder bonds may be formed on the one or more conductive contacts 836 to mechanically and/or electrically couple an integrated circuit die including the integrated circuit 800 with another component (e.g., a printed circuit board). The integrated circuit 800 may include additional or alternate structures to route the electrical signals from the interconnect layers 806-810; for example, the conductive contacts 836 may include other analogous features (e.g., posts) that route the electrical signals to external components.

In some embodiments in which the integrated circuit 800 is a double-sided die, the integrated circuit 800 may include another metallization stack (not shown) on the opposite side of the device layer(s) 804. This metallization stack may include multiple interconnect layers as discussed above with reference to the interconnect layers 806-810, to provide electrically conductive paths (e.g., including conductive lines and vias) between the device layer(s) 804 and additional conductive contacts (not shown) on the opposite side of the integrated circuit 800 from the conductive contacts 836.

In other embodiments in which the integrated circuit 800 is a double-sided die, the integrated circuit 800 may include one or more through-silicon vias (TSVs) through the die substrate 802; these TSVs may make contact with the device layer(s) 804, and may provide electrically conductive paths between the device layer(s) 804 and additional conductive contacts (not shown) on the opposite side of the integrated circuit 800 from the conductive contacts 836. In some embodiments, TSVs extending through the substrate can be used for routing power and ground signals from conductive contacts on the opposite side of the integrated circuit 800 from the conductive contacts 836 to the transistors 840 and any other components integrated into the die of the integrated circuit 800, and the metallization stack 819 can be used to route I/O signals from the conductive contacts 836 to transistors 840 and any other components integrated into the die of the integrated circuit 800.

Multiple integrated circuits 800 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

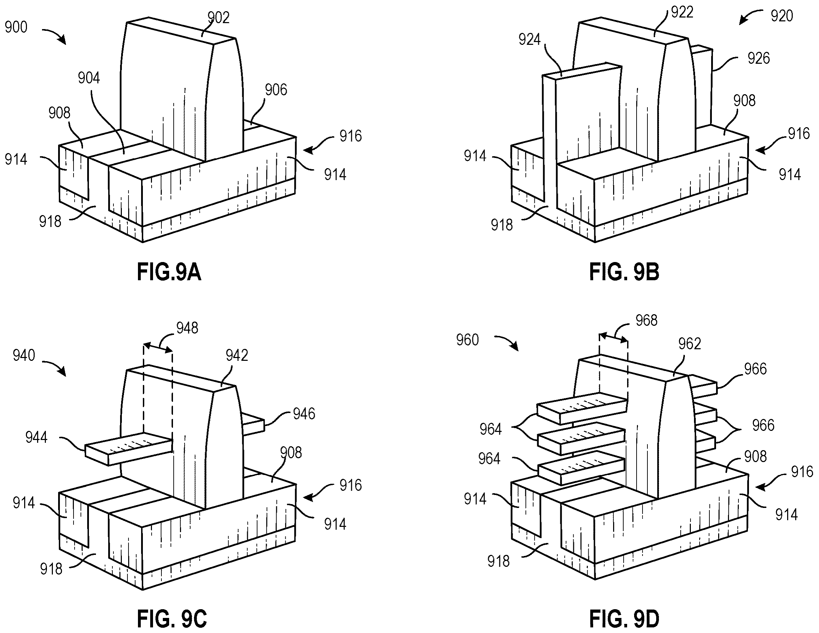

FIGS. 9A, 9B, 9C, and 9D are simplified perspective views of example planar, FinFET, gate-all-around, and stacked gate-all-around transistors. The transistors illustrated in FIGS. 9A-9D are formed on a substrate 916 having a surface 908. Isolation regions 914 separate the source and drain regions of the transistors from other transistors and from a bulk region 918 of the substrate 916.

FIG. 9A is a perspective view of an example planar transistor 900 comprising a gate 902 that controls current flow between a source region 904 and a drain region 906. The transistor 900 is planar in that the source region 904 and the drain region 906 are planar with respect to the substrate surface 908.

FIG. 9B is a perspective view of an example FinFET transistor 920 comprising a gate 922 that controls current flow between a source region 924 and a drain region 926. The transistor 920 is non-planar in that the source region 924 and the drain region 926 comprise "fins" that extend upwards from the substrate surface 908. As the gate 922 encompasses three sides of the semiconductor fin that extends from the source region 924 to the drain region 926, the transistor 920 can be considered a tri-gate transistor. FIG. 9B illustrates one S/D fin extending through the gate 922, but multiple S/D fins can extend through the gate of a FinFET transistor.

FIG. 9C is a perspective view of a gate-all-around (GAA) transistor 940 comprising a gate 942 that controls current flow between a source region 944 and a drain region 946. The transistor 940 is non-planar in that the source region 944 and the drain region 946 are elevated from the substrate surface 908.

FIG. 9D is a perspective view of a GAA transistor 960 comprising a gate 962 that controls current flow between multiple elevated source regions 964 and multiple elevated drain regions 966. The transistor 960 is a stacked GAA transistor as the gate controls the flow of current between multiple elevated S/D regions stacked on top of each other. The transistors 940 and 960 are considered gate-all-around transistors as the gates encompass all sides of the semiconductor portions that extend from the source regions to the drain regions. The transistors 940 and 960 can alternatively be referred to as nanowire, nanosheet, or nanoribbon transistors depending on the width (e.g., widths 948 and 968 of transistors 940 and 960, respectively) of the semiconductor portions extending through the gate.

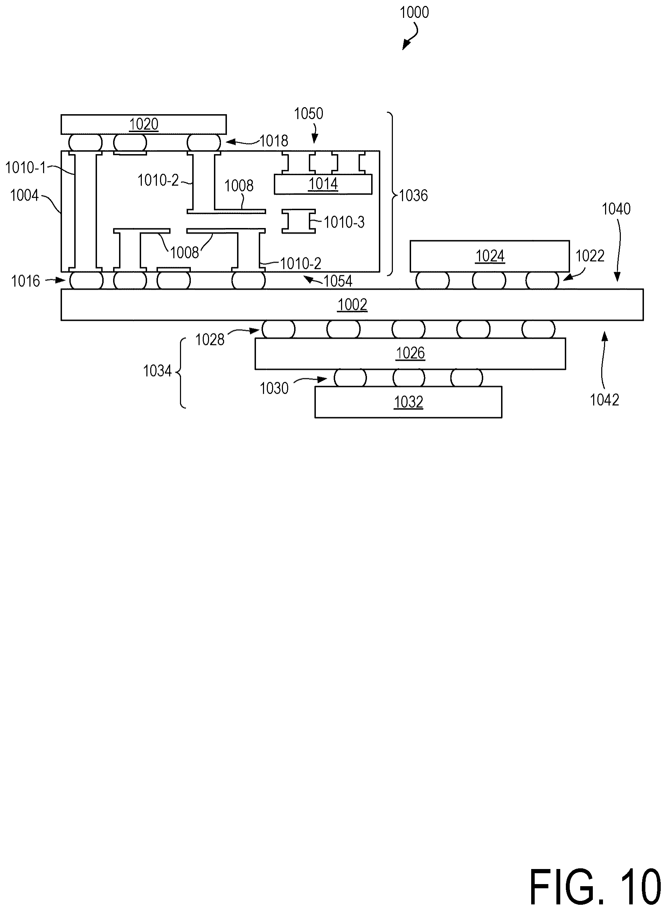

FIG. 10 is a cross-sectional side view of a microelectronic assembly 1000 that may include any of the embodiments disclosed herein. The microelectronic assembly 1000 includes multiple integrated circuit components disposed on a circuit board 1002 (which may be a motherboard, system board, mainboard, etc.). The microelectronic assembly 1000 may include components disposed on a first face 1040 of the circuit board 1002 and an opposing second face 1042 of the circuit board 1002; generally, components may be disposed on one or both faces 1040 and 1042.

In some embodiments, the circuit board 1002 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1002. In other embodiments, the circuit board 1002 may be a non-PCB substrate. The microelectronic assembly 1000 illustrated in FIG. 10 includes a package-on-interposer structure 1036 coupled to the first face 1040 of the circuit board 1002 by coupling components 1016. The coupling components 1016 may electrically and mechanically couple the package-on-interposer structure 1036 to the circuit board 1002, and may include solder balls (as shown in FIG. 10), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 1036 may include an integrated circuit component 1020 coupled to an interposer 1004 by coupling components 1018. The coupling components 1018 may take any suitable form for the application, such as the forms discussed above with reference to the coupling components 1016. Although a single integrated circuit component 1020 is shown in FIG. 10, multiple integrated circuit components may be coupled to the interposer 1004; indeed, additional interposers may be coupled to the interposer 1004. The interposer 1004 may provide an intervening substrate used to bridge the circuit board 1002 and the integrated circuit component 1020.

The integrated circuit component 1020 may be a packaged or unpackaged integrated circuit component that includes one or more integrated circuit dies (e.g., the die 702 of FIG. 7, the integrated circuit 800 of FIG. 8) and/or one or more other suitable components.

The unpackaged integrated circuit component 1020 comprises solder bumps attached to contacts on the die. The solder bumps allow the die to be directly attached to the interposer 1004. In embodiments where the integrated circuit component 1020 comprises multiple integrated circuit die, the die can be of the same type (a homogeneous multi-die integrated circuit component) or of two or more different types (a heterogeneous multi-die integrated circuit component). In addition to comprising one or more processor units, the integrated circuit component 1020 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate, or combinations thereof. A packaged multi-die integrated circuit component can be referred to as a multi-chip package (MCP) or multi-chip module (MCM).

The interposer 1004 may spread connections to a wider pitch or reroute a connection to a different connection. For example, the interposer 1004 may couple the integrated circuit component 1020 to a set of ball grid array (BGA) conductive contacts of the coupling components 1016 for coupling to the circuit board 1002. In the embodiment illustrated in FIG. 10, the integrated circuit component 1020 and the circuit board 1002 are attached to opposing sides of the interposer 1004; in other embodiments, the integrated circuit component 1020 and the circuit board 1002 may be attached to a same side of the interposer 1004. In some embodiments, three or more components may be interconnected by way of the interposer 1004.

In some embodiments, the interposer 1004 may be formed as a PCB, including multiple metal layers separated from one another by layers of dielectric material and interconnected by electrically conductive vias. In some embodiments, the interposer 1004 may be formed of an epoxy resin, a fiberglass-reinforced epoxy resin, an epoxy resin with inorganic fillers, a ceramic material, or a polymer material such as polyimide. In some embodiments, the interposer 1004 may be formed of alternate rigid or flexible materials that may include the same materials described above for use in a semiconductor substrate, such as silicon, germanium, and other group III-V and group IV materials. The interposer 1004 may include metal interconnects 1008 and vias 1010, including but not limited to through hole vias 1010-1 (that extend from a first face 1050 of the interposer 1004 to a second face 1054 of the interposer 1004), blind vias 1010-2 (that extend from the first or second faces 1050 or 1054 of the interposer 1004 to an internal metal layer), and buried vias 1010-3 (that connect internal metal layers).

In some embodiments, the interposer 1004 can comprise a silicon interposer. Through-silicon vias (TSV) extending through the silicon interposer can connect connections on the first face of a silicon interposer to an opposing second face of the silicon interposer. In some embodiments, an interposer 1004 comprising a silicon interposer can further comprise one or more routing layers to route connections on a first face of the interposer 1004 to an opposing second face of the interposer 1004.

The interposer 1004 may further include embedded devices 1014, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1004. The package-on-interposer structure 1036 may take the form of any of the package-on-interposer structures known in the art.

The integrated circuit assembly 1000 may include an integrated circuit component 1024 coupled to the first face 1040 of the circuit board 1002 by coupling components 1022. The coupling components 1022 may take the form of any of the embodiments discussed above with reference to the coupling components 1016, and the integrated circuit component 1024 may take the form of any of the embodiments discussed above with reference to the integrated circuit component 1020.

The integrated circuit assembly 1000 illustrated in FIG. 10 includes a package-on-package structure 1034 coupled to the second face 1042 of the circuit board 1002 by coupling components 1028. The package-on-package structure 1034 may include an integrated circuit component 1026 and an integrated circuit component 1032 coupled together by coupling components 1030 such that the integrated circuit component 1026 is disposed between the circuit board 1002 and the integrated circuit component 1032. The coupling components 1028 and 1030 may take the form of any of the embodiments of the coupling components 1016 discussed above, and the integrated circuit components 1026 and 1032 may take the form of any of the embodiments of the integrated circuit component 1020 discussed above. The package-on-package structure 1034 may be configured in accordance with any of the package-on-package structures known in the art.

FIG. 11 is a block diagram of an example electrical device 1100 that may include one or more of the embodiments disclosed herein. For example, any suitable ones of the components of the electrical device 1100 may include one or more of the disclosed embodiments, semiconductor assemblies, package assemblies, microelectronic assemblies 1000, integrated circuit components 1020, integrated circuits 800, integrated circuit dies 702, or structures disclosed herein, attached on a printed circuit board 1101. A number of components are illustrated in FIG. 11 as included in the electrical device 1100, but any one or more of these components may be omitted or duplicated, as suitable for the application. In some embodiments, some or all the components included in the electrical device 1100 may be attached to one or more motherboards, mainboards, printed circuit boards, or system boards. In some embodiments, one or more of these components are fabricated onto a single system-on-a-chip (SoC) die. In various embodiments, the electrical device 1100 is enclosed by, or integrated with, a housing 1103.

Additionally, in various embodiments, the electrical device 1100 may not include one or more of the components illustrated in FIG. 11, but the electrical device 1100 may include interface circuitry for coupling to the one or more components. For example, the electrical device 1100 may not include a display device 1106, but may include display device interface circuitry (e.g., a connector and driver circuitry) to which a display device 1106 may be coupled. In another set of examples, the electrical device 1100 may not include an audio input device 1124 or an audio output device 1108, but may include audio input or output device interface circuitry (e.g., connectors and supporting circuitry) to which an audio input device 1124 or audio output device 1108 may be coupled.

The electrical device 1100 may include one or more processor units 1102 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1102 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller crypto processors (specialized processors that execute cryptographic algorithms within hardware), server processors, controllers, or any other suitable type of processor units. As such, the processor unit can be referred to as an XPU (or xPU).

The electrical device 1100 may include a memory 1104, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1104 may include memory that is located on the same integrated circuit die as the processor unit 1102. This memory may be used as cache memory (e.g., Level 1 (L1), Level 2 (L2), Level 3 (L3), Level 4 (L4), Last Level Cache (LLC)) and may include embedded dynamic random-access memory (eDRAM) or spin transfer torque magnetic random-access memory (STT-MRAM).

In some embodiments, the electrical device 1100 can comprise one or more processor units 1102 that are heterogeneous or asymmetric to another processor unit 1102 in the electrical device 1100. There can be a variety of differences between the processor units 1102 in a system in terms of a spectrum of metrics of merit including architectural, microarchitectural, thermal, power consumption characteristics, and the like. These differences can effectively manifest themselves as asymmetry and heterogeneity among the processor units 1102 in the electrical device 1100.

In some embodiments, the electrical device 1100 may include a communication component 1112 (e.g., one or more communication components). For example, the communication component 1112 can manage wireless communications for the transfer of data to and from the electrical device 1100. The term "wireless" and its derivatives may be used to describe circuits, devices, systems, methods, techniques, communications channels, etc., that may communicate data using modulated electromagnetic radiation through a nonsolid medium. The term "wireless" does not imply that the associated devices do not contain any wires, although in some embodiments they might not.

The communication component 1112 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra-mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1112 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1112 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1112 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1112 may operate in accordance with other wireless protocols in other embodiments. The electrical device 1100 may include an antenna 1122 to facilitate wireless communications and/or to receive other wireless communications (such as AM or FM radio transmissions).

In some embodiments, the communication component 1112 may manage wired communications, such as electrical, optical, or any other suitable communication protocols (e.g., IEEE 802.3 Ethernet standards). As noted above, the communication component 1112 may include multiple communication components. For instance, a first communication component 1112 may be dedicated to shorter-range wireless communications such as Wi-Fi or Bluetooth, and a second communication component 1112 may be dedicated to longer-range wireless communications such as global positioning system (GPS), EDGE, GPRS, CDMA, WiMAX, LTE, EV-DO, or others. In some embodiments, a first communication component 1112 may be dedicated to wireless communications, and a second communication component 1112 may be dedicated to wired communications.

The electrical device 1100 may include power supply such as a battery/power circuitry 1114. The battery/power circuitry 1114 may include one or more energy storage devices (e.g., batteries or capacitors) and/or circuitry for coupling components of the electrical device 1100 to an energy source separate from the electrical device 1100 (e.g., AC line power).

The electrical device 1100 may include a display device 1106 (or corresponding interface circuitry, as discussed above). The display device 1106 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1100 may include an audio output device 1108 (or corresponding interface circuitry, as discussed above). The audio output device 1108 may include any embedded or wired or wirelessly connected external device that generates an audible indicator, such speakers, headsets, or earbuds.

The electrical device 1100 may include an audio input device 1124 (or corresponding interface circuitry, as discussed above). The audio input device 1124 may include any embedded or wired or wirelessly connected device that generates a signal representative of a sound, such as microphones, microphone arrays, or digital instruments (e.g., instruments having a musical instrument digital interface (MIDI) output). The electrical device 1100 may include a Global Navigation Satellite System (GNSS) device 1118 (or corresponding interface circuitry, as discussed above), such as a Global Positioning System (GPS) device. The GNSS device 1118 may be in communication with a satellite-based system and may determine a geolocation of the electrical device 1100 based on information received from one or more GNSS satellites, as known in the art.

The electrical device 1100 may include another output device 1110 (or corresponding interface circuitry, as discussed above). Examples of the other output device 1110 may include an audio codec, a video codec, a printer, a wired or wireless transmitter for providing information to other devices, or an additional storage device.

The electrical device 1100 may include another input device 1120 (or corresponding interface circuitry, as discussed above). Examples of the other input device 1120 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1100 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1100 may be any other electronic device that processes data. In some embodiments, the electrical device 1100 may comprise multiple discrete physical components. Given the range of devices that the electrical device 1100 can be manifested as in various embodiments, in some embodiments, the electrical device 1100 can be referred to as a computing device or a computing system.

While at least one embodiment has been presented in the foregoing detailed description, it should be appreciated that a vast number of variations exist. It should also be appreciated that the disclosed embodiments are only examples, and are not intended to limit the scope, applicability, or configuration of the disclosure in any way. Rather, the foregoing detailed description will provide those skilled in the art with a convenient road map for implementing the disclosed embodiment embodiments. Various changes can be made in the function and arrangement of elements without departing from the scope of the disclosure as set forth in the appended claims and the legal equivalents thereof.

As used herein, the term "adjacent" refers to layers or components that are in direct physical contact with each other, with no layers or components in between them. For example, a layer X that is adjacent to a layer Y refers to a layer that is in direct physical contact with layer Y. In contrast, as used herein, the phrase(s) "located on" (in the alternative, "located under," "located above/over," or "located next to," in the context of a first layer or component located on a second layer or component) includes (i) configurations in which the first layer or component is directly physically attached to the second layer (i.e., adjacent), and (ii) component and configurations in which the first layer or component is attached (e.g. coupled) to the second layer or component via one or more intervening layers or components.

Terms or values modified by the word "substantially" include arrangements, orientations, spacings, or positions that vary plus or minus 20% from the meaning of the unmodified term or value. Terms or values modified by the word "about" include values inclusive of 10% less than the term or value to inclusive of 10% greater than the term or value.

As used herein, the term "electronic component" can refer to an active electronic circuit (e.g., processing unit, memory, storage device, FET) or a passive electronic circuit (e.g., resistor, inductor, capacitor).

As used herein, the term "integrated circuit component" can refer to an electronic component configured on a semiconducting material to perform a function. An integrated circuit (IC) component can comprise one or more of any computing system components described or referenced herein or any other computing system component, such as a processor unit (e.g., system-on-a-chip (SoC), processor core, graphics processor unit (GPU), accelerator, chipset processor), I/O controller, memory, or network interface controller, and can comprise one or more additional active or passive devices such as capacitors, decoupling capacitors, resistors, inductors, fuses, diodes, transformers, sensors, electrostatic discharge (ESD) devices, and memory devices.

A non-limiting example of an unpackaged integrated circuit component includes a single monolithic integrated circuit die (also shortened herein to "die"); the die may include solder bumps attached to contacts on the die. When present on the die, the solder bumps or other conductive contacts can enable the die to be directly attached to a printed circuit board (PCB) or other substrates.

A non-limiting example of a packaged integrated circuit component comprises one or more integrated circuit dies mounted on a package substrate with the integrated circuit dies and package substrate encapsulated in a casing material, such as a metal, plastic, glass, or ceramic. Often the casing includes an integrated heat spreader (IHS); the packaged integrated circuit component often has bumps, leads, or pins attached to the package substrate (either directly or by wires attaching the bumps, leads, or pins to the package substrate) for attaching the packaged integrated circuit component to a printed circuit board (or motherboard or base board) or another component.

As used herein, phrases such as "an embodiment," "various embodiments," "some embodiments," and the like, indicate that some embodiments may have some, all, or none of the features described for other embodiments. "First," "second," "third," and the like describe a common object and indicate different instances of like objects being referred to; unless specifically stated, they do not imply a given sequence, either temporally or spatially, in ranking, or any other manner. In accordance with patent application parlance, "connected" indicates elements that are in direct physical or electrical contact with each other and "coupled" indicates elements that cooperate or interact with each other, coupled elements may or may not be in direct physical or electrical contact. Furthermore, the terms "comprising," "including," "having," and the like, are utilized synonymously to denote non-exclusive inclusions.

As used in this application and the claims, a list of items joined by the term "at least one of" or the term "one or more of" can mean any combination of the listed terms. For example, the phrase "at least one of A, B or C" can mean A; B; C; A and B; A and C; B and C; or A, B, and C. Likewise, the phrase "one or more of A, B and C" can mean A; B; C; A and B; A and C; B and C; or A, B, and C.

As used in this application and the claims, the phrase "individual of" or "respective of" following by a list of items recited or stated as having a trait, feature, etc. means that all the items in the list possess the stated or recited trait, feature, etc. For example, the phrase "individual of A, B, or C, comprise a sidewall" or "respective of A, B, or C, comprise a sidewall" means that A comprises a sidewall, B comprises sidewall, and C comprises a sidewall.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

The following examples pertain to additional embodiments of technologies disclosed herein.

### EXAMPLES

Example 1 is an apparatus comprising: an isolation layer comprising a negative metal oxide semiconductor (NMOS) region and a positive metal oxide semiconductor (PMOS) region; one or more channels for electrical communication through the isolation layer between the NMOS region and PMOS region; a first cavity formed in an upper surface of the isolation layer and extending orthogonally into the NMOS region to a first depth; a second cavity formed in the upper surface of the isolation layer and extending orthogonally into the PMOS region to a second depth; and wherein the first depth is more than four times the second depth.

Example 2 includes the subject matter of Example 1, wherein the first cavity has a V-shaped profile in a cross-sectional image, with an aspect ratio in a range of 0.25-0.4.

Example 3 includes the subject matter of Example 1 or Example 2, wherein the second cavity has a flat or oval shaped bottom in a cross-sectional image.

Example 4 includes the subject matter of Example 1 or Example 2, wherein the second cavity has an arrow-shaped bottom in a cross-sectional image.

Example 5 includes the subject matter of Example 1 or Example 2, further comprising: a fill material distributed in the first cavity to thereby create a first NMOS contact; the first NMOS contact to provide a first continuous electrical path between the upper surface and a bottom of the first cavity; the fill material distributed in the second cavity to thereby create a first PMOS contact; the first PMOS contact to provide a second continuous electrical path between the upper surface and a bottom of the second cavity.

Example 6 includes the subject matter of Example 5, wherein the fill material comprises a conductive material.

Example 7 includes the subject matter of Example 6, wherein the fill material comprises one or more of: tungsten, antimony, bismuth, platinum, palladium, copper, aluminum, nickel, cobalt, iron, tin, gold, and silver.

Example 8 includes the subject matter of any one of Examples 5-7, further comprising a conductive liner layer surrounding the fill material in the first cavity and in the second cavity.

Example 9 includes the subject matter of Example 1, wherein the NMOS region is a first NMOS region, the PMOS region is a first PMOS region, and further comprising: a second NMOS region in the isolation layer and electrically coupled via a plurality of N-channels to the first NMOS region; a second PMOS region in the isolation layer and electrically coupled via a plurality of P-channels to the first PMOS region; a first gate structure in the isolation layer between the first NMOS region and the second NMOS region; a second gate structure in the isolation layer between the first PMOS region and the second PMOS region; a third cavity formed in the upper surface of the isolation layer and extending orthogonally into the second NMOS region to the first depth; a fourth cavity formed in the upper surface of the isolation layer and extending orthogonally into the second PMOS region to the second depth; and wherein the first cavity, the second cavity, the third cavity, and the fourth cavity are filled with a conductive material.

Example 10 is a multi-die assembly, comprising: a printed circuit board; and an integrated circuit die attached to the printed circuit board; the integrated circuit die comprising: an isolation layer comprising a plurality of negative metal oxide semiconductor (NMOS) regions and a plurality of positive metal oxide semiconductor (PMOS) regions; wherein NMOS regions have a respective NMOS contact characterized by a first cavity formed in an upper surface of the isolation layer, extending orthogonally into the NMOS region to a first depth, and filled with a conductive material; wherein PMOS regions have a respective PMOS contact characterized by a second cavity formed in the upper surface of the isolation layer, extending orthogonally into the PMOS region to a second depth, and filled with the conductive material; and wherein the first depth is more than four times the second depth.

Example 11 includes the subject matter of Example 10, wherein the first cavity has a V-shaped profile in a cross-sectional image, with an aspect ratio in a range of 0.25-0.4.

Example 12 includes the subject matter of Example 10 or Example 11, wherein the second cavity has a flat or oval shaped bottom in a cross-sectional image.

Example 13 includes the subject matter of Example 10 or Example 11, wherein the second cavity has an arrow-shaped bottom in a cross-sectional image.

Example 14 includes the subject matter of any one of Examples 10-13, wherein respective NMOS contacts and respective PMOS contacts further comprise a liner layer of less than or equal to 15 nanometers +/-5 nanometers (nm) surrounding the conductive material.

Example 15 includes the subject matter of Example 14, wherein the liner layer comprises titanium.

Example 16 is a method, comprising: processing one or more complementary metal oxide semiconductor (CMOS) wafers up to a task of creating NMOS contacts and PMOS contacts; creating the NMOS contacts by etching trench cavities of more than 50 nanometers into source regions; creating the PMOS contacts by etching cavities of less than 10 nanometers into drain regions; and filling the NMOS contacts and the PMOS contacts with a conductive fill material.

Example 17 includes the subject matter of Example 16, further comprising, lining the trench cavities and the cavities with 15 nanometers +/- 5 nanometers of titanium before filling the NMOS contacts and the PMOS contacts.

Example 18 includes the subject matter of Example 16 or Example 17, further comprising etching the trench cavities to have a needle shape in a cross-sectional image.

Example 19 includes the subject matter of Example 18, further comprising etching the cavities to have a flat or oval shape bottom in the cross-sectional image.

Example 20 includes the subject matter of Example 18, further comprising etching the cavities to have an arrow shaped bottom in the cross-sectional image.

## Claims

1. An apparatus comprising:
an isolation layer comprising a negative metal oxide semiconductor (NMOS) region and a positive metal oxide semiconductor (PMOS) region;
one or more channels for electrical communication through the isolation layer between the NMOS region and PMOS region;
a first cavity formed in an upper surface of the isolation layer and extending orthogonally into the NMOS region to a first depth;
a second cavity formed in the upper surface of the isolation layer and extending orthogonally into the PMOS region to a second depth; and
wherein the first depth is more than four times the second depth.

2. The apparatus of claim 1, wherein the first cavity has a V-shaped profile in a cross-sectional image, with an aspect ratio in a range of 0.25-0.4.

3. The apparatus of any of claims 1-2, wherein the second cavity has a flat or oval shaped bottom in a cross-sectional image.

4. The apparatus of any of claims 1-2, wherein the second cavity has an arrow-shaped bottom in a cross-sectional image.

5. The apparatus of any of claims 1-4, further comprising:
a fill material distributed in the first cavity to thereby create a first NMOS contact;
the first NMOS contact to provide a first continuous electrical path between the upper surface and a bottom of the first cavity;
the fill material distributed in the second cavity to thereby create a first PMOS contact;
the first PMOS contact to provide a second continuous electrical path between the upper surface and a bottom of the second cavity.

6. The apparatus of claim 5, wherein the fill material comprises a conductive material.

7. The apparatus of claim 6, wherein the fill material comprises one or more of: tungsten, antimony, bismuth, platinum, palladium, copper, aluminum, nickel, cobalt, iron, tin, gold, and silver.

8. The apparatus of any of claims 5-7, further comprising a conductive liner layer surrounding the fill material in the first cavity and in the second cavity.

9. The apparatus of any of claims 1-8, wherein the NMOS region is a first NMOS region, the PMOS region is a first PMOS region, and further comprising:
a second NMOS region in the isolation layer and electrically coupled via a plurality of N-channels to the first NMOS region;
a second PMOS region in the isolation layer and electrically coupled via a plurality of P-channels to the first PMOS region;
a first gate structure in the isolation layer between the first NMOS region and the second NMOS region;
a second gate structure in the isolation layer between the first PMOS region and the second PMOS region;
a third cavity formed in the upper surface of the isolation layer and extending orthogonally into the second NMOS region to the first depth;
a fourth cavity formed in the upper surface of the isolation layer and extending orthogonally into the second PMOS region to the second depth; and
wherein the first cavity, the second cavity, the third cavity, and the fourth cavity are filled with a conductive material.

10. A method, comprising:
processing one or more complementary metal oxide semiconductor (CMOS) wafers up to a task of creating NMOS contacts and PMOS contacts;
creating the NMOS contacts by etching trench cavities of more than 50 nanometers into source regions;
creating the PMOS contacts by etching cavities of less than 10 nanometers into drain regions; and
filling the NMOS contacts and the PMOS contacts with a conductive fill material.

11. The method of claim 10, further comprising, lining the trench cavities and the cavities with 15 nanometers +/- 5 nanometers of titanium before filling the NMOS contacts and the PMOS contacts.

12. The method of any of claims 10-11, further comprising etching the trench cavities to have a needle shape in a cross-sectional image.

13. The method of claim 12, further comprising etching the cavities to have a flat or oval shape bottom in the cross-sectional image.

14. The method of claim 12, further comprising etching the cavities to have an arrow shaped bottom in the cross-sectional image.
